# EUROPEAN PATENT SPECIFICATION

(11) **EP 2 838 128 B1**
(45) Date of publication and mention of the grant of the patent: **06.01.2016**
(21) Application number: 13180787.7
(22) Date of filing: 16.08.2013
(51) Int. Cl.: H01L 51/00, H01G 9/20, C09B 23/01

(54) **Dye-sensitized solar cells and methods of making same**
Farbstoffsensibilisierte Solarzellen und Verfahren zu deren Herstellung
Cellules solaires à colorant et leurs procédés de fabrication

(43) Date of publication of application: 18.02.2015
(73) Proprietor: Honeywell Romania S.R.L., 014459 Bucharest (RO)
(72) Inventor: Serban, Bogdan Catalin, 60000 Bucharest (RO); Diaconu, Cristian, 020273 Bucharest (RO); Milhaila, Mihai N., 023555 Bucharest (RO); Buiu, Octavian, 014459 Bucharest (RO)
(74) Representative: Houghton, Mark Phillip

(56) References cited:
- US-A1- 2013 125 987

## Description

### FIELD OF INVENTION

The present disclosure relates to dye-sensitized solar cells and a method for making same. More particularly, the disclosure relates to a dye-sensitized solar cell that utilizes 10*H*-phenoxazine- or triphenylamine-based dyes as the dye-sensitizers.

### BACKGROUND OF THE INVENTION

Dye-sensitized solar cells (DSSC) provide a technically and economically credible alternative concept to present day p-n junction photovoltaic devices (M. Grätzel, Journal of Photochemistry and Photobiology C: Photochemistry Reviews 4: 145-153 (2003). *See also,* Wei-Hao Lai et al., Journal of Photochemistry and Photobiology A: Chemistry 195: 307-313 (2008); and Xiao-Feng Wang et al., Langmuir 26: 6320-6327 (2010)). A further relevant disclosure can be found in JP 2012-138269 which discloses a photoelectric conversion element and a solar battery. In contrast to the conventional systems where the semiconductor assumes both the task of light absorption and charge carrier transport, the two functions are separated in the case of DSSCs. Light is absorbed by a sensitizer, which is anchored to the surface of a semiconductor. Charge separation takes place at the interface via photo-induced electron injection from the dye into the conduction band of the solid. Carriers are transported in the conduction band of the semiconductor to the charge collector. The use of sensitizers having a broad absorption band in conjunction with oxide films of nanocrystalline morphology permits the harvesting of a large fraction of sunlight, with nearly quantitative conversion of incident photon into electric current over a large spectral range extending from the UV to the near IR region.

Tetrapyrrole macrocycles, including chlorophylls, have attracted attention in the past in DSSC applications as sensitizers primarily because they are known chromrophores that play an important role in natural photosynthetic processes. It is known, however, that tetrapyrrole macrocycles suffer some drawbacks due in part to their lack of red light and near IR absorption. There is therefore a need in the art for other sensitizers that do not suffer from some of these drawbacks. The embodiments of the present address this need.

### SUMMARY OF THE INVENTION

The embodiments of the present disclosure focus on 10*H*-phenoxazine- or triphenylamine-base in DSSC applications.

In Embodiment 1, the invention relates to a dye-sensitized solar cell comprising one or more dyes comprising a compound of the formula (I): 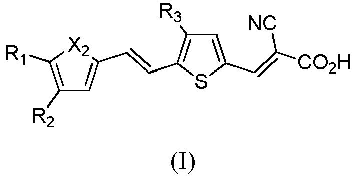 wherein R₁ is a moiety of the formula (II): 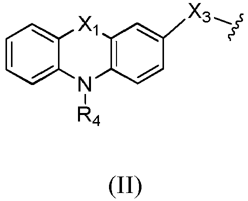 wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur.

In Embodiment 2, the invention relates to a method of preparing a dye sensitized solar cell comprising:
forming a first conductive layer on a first substrate;
forming a barrier layer on the first conductive layer;
forming a TiO₂ nanoparticulate layer;
forming a TiO₂ microparticulate layer on the TiO₂ nanoparticulate layer;
disposing a dye on the TiO₂ nanoparticulate layer and/or the TiO₂ microparticulate layer, wherein the dye comprises a compound of the formula (I): 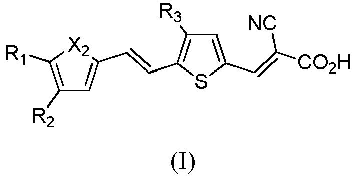
wherein R₁ is a moiety of the formula (II): 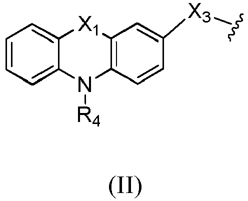
wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur;
forming a second conductive layer on a second substrate; and
providing a regenerating composition between the second conductive layer and the barrier layer.

In Embodiment 3, the invention relates to the dye-sensitized solar cell of Embodiment 3, further comprising:
a first conductive layer disposed on a first substrate;
a barrier layer disposed on the first conductive layer;
a TiO₂ nanoparticulate layer disposed on the barrier layer;
a TiO₂ microparticulate layer disposed on the TiO₂ nanoparticulate layer;
a dye disposed on the TiO₂ nanoparticulate layer and/or the TiO₂ microparticulate layer, wherein the dye comprises a compound of the formula (I): 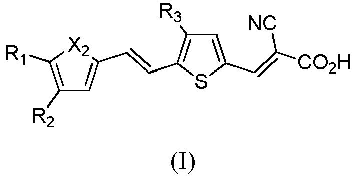
wherein R₁ is a moiety of the formula (II): 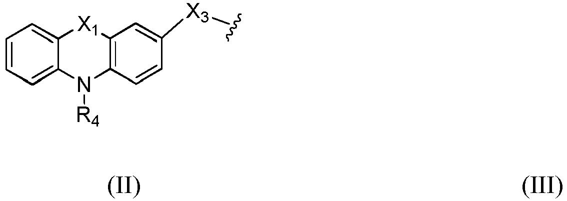
wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur;
a second conductive layer disposed on a second substrate; and
a regenerating composition disposed between the second conductive layer and
the TiO₂ microparticulate layer.

In Embodiment 4, the invention relates to the method of Embodiment 2 or the dye-sensitized solar cell of Embodiment 3, wherein the R₁ is a moiety of the formula (II): 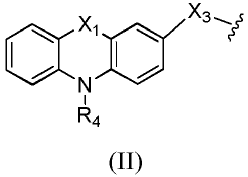 wherein the wavy line indicates the point of attachment to the ring comprising X₂ at the point where R₁ is located; X₁ is oxygen or sulfur; X₃ is absent or C₂-C₅ alkenyl; and R₄ is alkoxyaryl or C₃-C₁₈ alkyl.

In Embodiment 5, the invention relates to the method of Embodiment 2 or the dye-sensitized solar cell of Embodiment 3, wherein the compound of the formula (I) is a compound of the formula: 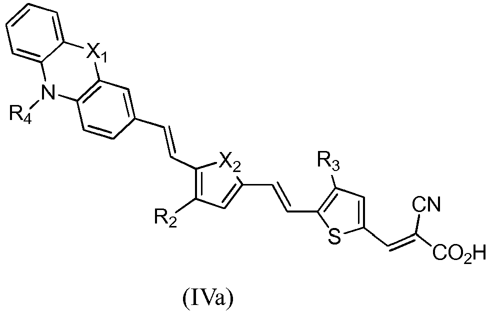 wherein X₁ is oxygen or sulfur; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur; or 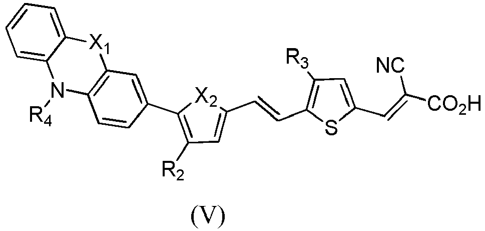 wherein X₁ is oxygen or sulfur; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur.

In Embodiment 7, the invention relates to the method or dye-sensitized solar cell of Embodiments 1 to 5, wherein X₂ is oxygen.

In Embodiment 8, the invention relates to the method or dye-sensitized solar cell of Embodiments 1 to 5, wherein X₂ is sulfur.

In Embodiment 9, the invention relates to the method or dye-sensitized solar cell of Embodiments 1 to 5, wherein X₁ is oxygen and X₂ is oxygen; X₁ is sulfur and X₂ is sulfur; X₁ is oxygen and X₂ is sulfur; or X₁ is sulfur and X₂ is oxygen.

In Embodiment 10, the invention relates to the method of Embodiment 2 or the dye-sensitized solar cell of Embodiment 3, wherein the first and/or second substrate comprises glass or a flexible polymer.

In Embodiment 11, the invention relates to the method or dye-sensitized solar cell of Embodiment 10, wherein the first and/or second substrate comprises a flexible polymer comprising poly(ethylene terephthalate), poly(ethylene naphthalate) or mixtures thereof.

In Embodiment 12, the invention relates to the method of Embodiment 2 or the dye-sensitized solar cell of Embodiment 3, wherein the first conductive layer comprises indium tin oxide (ITO), aluminum doped zinc oxide (AZO), antimony doped tin dioxide (ATO), fluorine doped tin dioxide (FTO), tin-doped indium oxide or conductive impurity doped titanium oxide (TiO₂).

In Embodiment 13, the invention relates to the method of Embodiment 2 or the dye-sensitized solar cell of Embodiment 3, wherein the regenerating composition comprises iodide ions and iodine.

In Embodiment 14, the invention relates to the method of Embodiment 2 or the dye-sensitized solar cell of Embodiment 3, wherein the second conductive layer comprises platinum.

In Embodiment 15, the invention relates to a method of preparing a dye sensitized solar cell comprising:
providing a first substrate comprising a first conductive layer and a TiO₂ nanoparticulate layer;
disposing a dye on the TiO₂ nanoparticulate layer, wherein the dye comprises a compound of the formula (I): 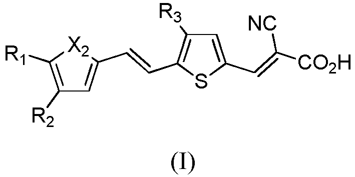
wherein R₁ is a moiety of the formula (II): 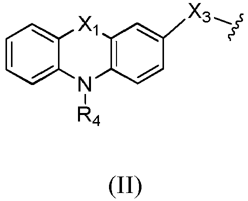
wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur; and
providing a second substrate comprising a second conductive layer.

### DETAILED DESCRIPTION OF THE DRAWINGS

FIG. 1 is a cross-section of a DSSC prepared by the methods disclosed herein.
FIGS. 2A to 2F are cross-sections of a DSSC according to an embodiment of the invention, as it is prepared by the methods disclosed herein.
FIG. 3 is a cross-section of a DSSC according to an embodiment of the invention.
FIG. 4 is a flow chart of the method of preparing a DSSC according to an embodiment of the invention.

### DETAILED DESCRIPTION OF THE INVENTION

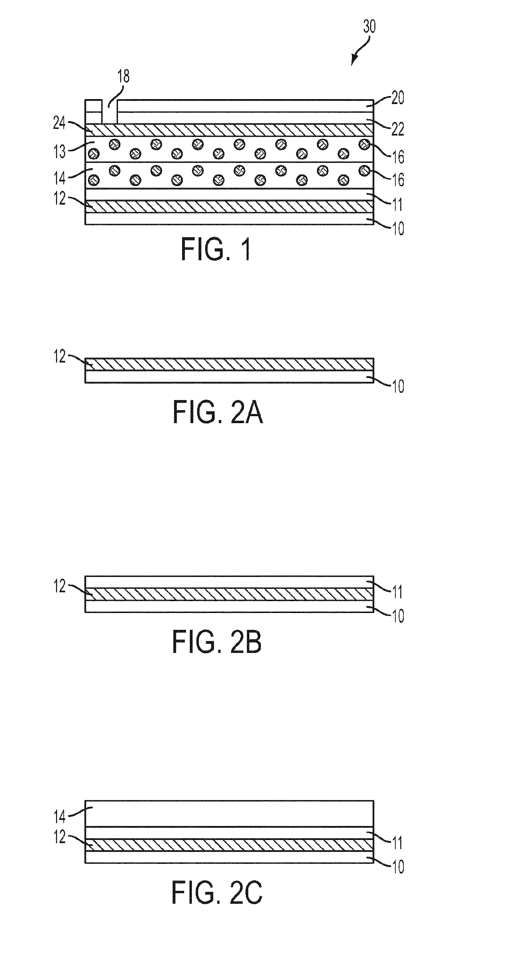

Embodiments of the present invention relate to a method of preparing a dye-sensitized solar cell. Making reference to FIG. 1, the method comprises forming a first conductive layer 12 on a first substrate 10. A barrier layer 11 is then formed on the conductive layer 12. A nanoparticulate layer 14 is subsequently formed on the metal oxide layer 11. A microparticulate layer 13 is subsequently formed on the nanoparticulate layer 14. The nanoparticulate layer 14 and the microparticulate layer 13 are subsequently functionalized with a dye 16. A second substrate 20 comprising a second conductive layer 22 is provided and a regenerating composition 24 (e.g., an electrolyte composition for regenerating the dye 16) is applied between the first substrate 10 and the second substrate 20, thereby completing the dye-sensitized solar cell 30. Those of skill in the art will appreciate that the regenerating composition 24, though shown as a layer in FIG. 1, will permeate the space between the barrier layer 11 and the second conductive layer 22. In some embodiments, the second substrate 20 comprises at least one orifice 18 that goes through the second substrate 20 and the second conductive layer 22 and allows for the application of the regenerating composition 24.

Although the layers shown in FIG. 1 (and others) are shown as being in direct contact with one another, it should be understood that, in some embodiments, there could be one or more layers in between the layers depicted in FIG. 1.

More specifically, referring to FIG. 2A, a first substrate 10 is provided. The first substrate 10 may comprises any suitable material and may be rigid, flexible, transparent, semitransparent, metallic or semiconducting. In some embodiments, the first substrate 10 may be glass or polymeric in nature, *e.g*., flexible polymers including, but not limited to, poly(ethylene terephthalate, poly(ethylene naphthalate) or mixtures thereof.

In FIG. 2A, a first conductive layer 12 is formed on the first substrate 10 to provide a path for electron flow. In some embodiments, the first conductive layer 12 may be substantially smooth. In other embodiments, the first conductive layer 12 may comprise protrusions that may be characterized as nanowires or nanorods. *See, e.g.,* Published U.S. Patent Appl. No. 2008/0041446, which is incorporated by reference as if fully set forth herein. In some embodiments, the first conductive layer 12 is formed by an *in situ* process including, but not limited to, thermal evaporation, sputtering or other applicable processes well-known in the art. For example, the first conductive layer 12, comprising, *e.g*., indium tin oxide, may be formed on the first substrate 10, and then stacked and saturated in a vapor of indium tin oxide by thermal evaporation. The first conductive layer 12 is formed at a temperature, *e.g*., between 400°C and 950°C for 5 minutes to 60 minutes.

In some embodiments, the first conductive layer 12 comprises indium tin oxide (ITO), aluminum doped zinc oxide (AZO), antimony doped tin dioxide (ATO), fluorine doped tin oxide (FTO), tin-doped indium oxide or other semiconductor oxides.

In some embodiments, the first substrate 10 is flexible. In some embodiments, the flexible substrate comprises poly(ethylene terephthalate) coated with a first conductive layer 12 comprising tin-doped indium oxide. In other embodiments, the flexible substrate comprises poly(ethylene naphthalate) coated with tin-doped indium oxide.

As shown in FIG. 2B, in some embodiments a barrier layer 11 is formed on the first conductive layer 12. The barrier layer 11 may be formed by, *e.g*., immersing the first substrate 10, comprising the conductive layer 12, in a TiCl₄ solution at 70°C. Following the immersion in the TiCl₄ solution, the first substrate 10 is heated at about 450°C for about 40 minutes. The resulting barrier layer 11 is, in some embodiments, a TiO₂ nanoparticulate layer having a 100-150 nm thicknes and having nanoparticles having an average diameter of about 3 nm. The barrier layer 11 is formed to, among other things, avoid contact between the conductive layer 12 and the regenerating composition 24.

As shown in FIG. 2C, a nanoparticulate layer 14 is then formed on the barrier layer 11 by, *e*.*g*., the doctor blade method or any other method known in the art. The nanoparticulate layer 14 is formed to, among other things, increase surface contact with the subsequently applied dye-sensitizer. The nanoparticulate layer 14 may take the form of nanoparticles, nanorods (*e.g*., nanowires) or quantum dots.

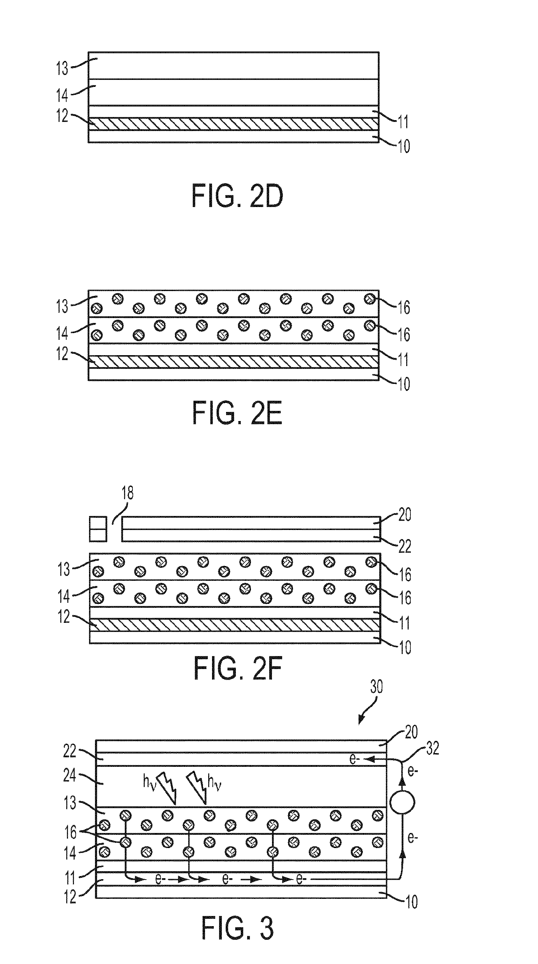

In FIG. 2D, a microparticulate layer 13 is formed on the nanoparticulate layer 14. The microparticulate layer 13 may be formed by, *e.g*., the doctor blade method or any other method known in the art. The newly-formed microparticulate layer 13 is heated at 450°C, for about 30 minutes and then allowed to cool slowly to a temperature of about 80°C. It is at about this temperature that the dye 16 is provided.

In FIG. 2E, a dye 16 is provided in the nanoparticulate layer 14 and in the microparticulate layer 13. In some embodiments, the dye 16 is adsorbed on the nanoparticulate layer 14 and the microparticulate layer 13, *e.g*., by dipping the substrate comprising the nanoparticulate layer 14 and the microparticulate layer 13 into a dye solution comprising the dye 16 at a concentration of about 0.3 mM to about 0.8 mM at room temperature for about 30 minutes to about 24 hours (*e.g*., from about 10 hours to about 24 hours). In some embodiments, the dye 16 comprises one or more dyes comprising a compound of the formula (I): 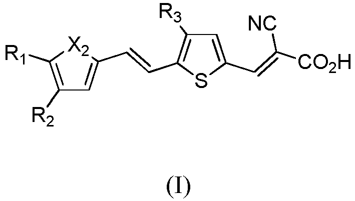 wherein R₁ is a moiety of the formula (II):

| | |
|---|---|
| 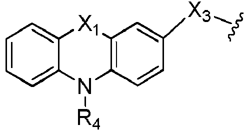 | |
| (II) | |

wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₅ is alkoxy; R₆ is alkoxy; R₂ is hydrogen or C₃-C₁₈ alkyl; R₃ is hydrogen or C₃-C₁₈ alkyl; and X₂ is oxygen or sulfur.

In some embodiments, the dye 16 comprises one or more dyes comprising a compound of the formula (I) defined by the formulae (IV)(X), wherein X₁-X₃ and R₁-R₆ are as defined above:

| | |
|---|---|
| 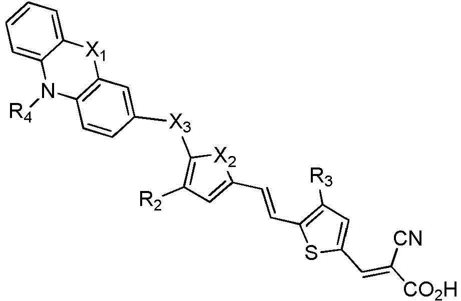 | (IV) |
| 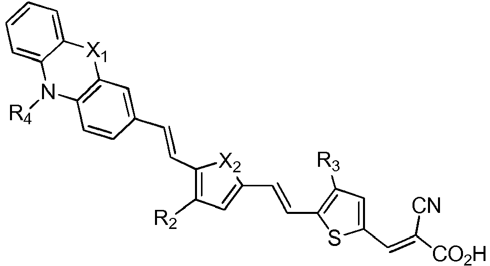 | (V) |
| 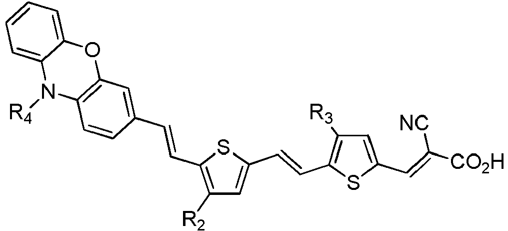 | (VI) |
| 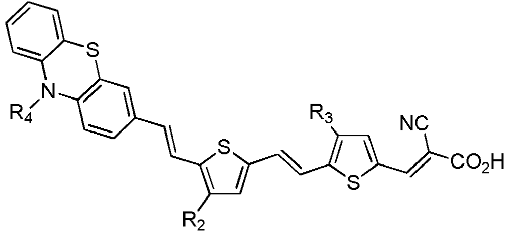 | (VII) |
| 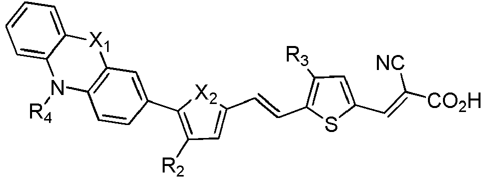 | (VIII) |
| 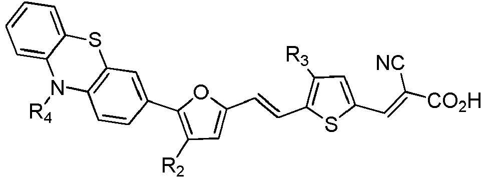 | (IX) |
| 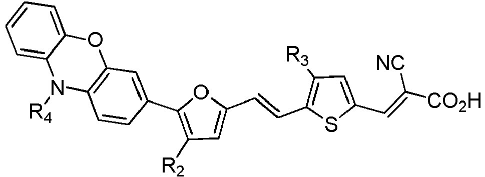 | (X) |
| | |

In some embodiments, with regard to the compound of the formula (VI), R₄ is alkoxyaryl, *e.g*., C₃-C₈ alkyl-O-phenyl, and C₆-alkyl-O-phenyl. In some embodiments, with regard to the compound of the formula (VI), R₄ is alkoxyaryl, *e.g.,* C₃-C₈ alkyl-O-phenyl, and C₆-alkyl-O-phenyl, R₂ is hydrogen, and R₃ is hydrogen. In other embodiments, with regard to the compound of the formula (VI), R₄ is alkoxyaryl, *e.g*., C₃-C₈ alkyl-O-phenyl, and C₆-alkyl-O-phenyl, R₂ is C₃-C₈ alkyl, *e.g*., C₆ alkyl, and R₃ is hydrogen.

In some embodiments, with regard to the compound of the formula (VI), R₄ is C₉-C₁₅ alkyl. In some embodiments, with regard to the compound of the formula (VI), R₄ is C₉-C₁₅ alkyl, R₂ is hydrogen, and R₃ is hydrogen. In some embodiments, with regard to the compound of the formula (VI), R₄ is C₉-C₁₅ alkyl, R₂ is C₃-C₈ alkyl, *e.g.,* C₆ alkyl, and R₃ is hydogen.

In some embodiments, with regard to the compound of the formula (VII), R₄ is C₉-C₁₅ alkyl. In some embodiments, with regard to the compound of the formulae (VII), R₄ is C₉-C₁₅ alkyl, R₂ is hydrogen, and R₃ is hydrogen. In some embodiments, with regard to the compound of the formula (VII), R₄ is C₉-C₁₅ alkyl, R₂ is C₃-C₈ alkyl, *e.g*., C₆ alkyl, and R₃ is hydrogen.

In some embodiments, with regard to the compound of the formula (VII), R₄ is alkoxyaryl, *e.g.,* C₃-C₈ alkyl-O-phenyl, and C₆-alkyl-O-phenyl. In some embodiments, with regard to the compound of the formulae (VII), R₄ is alkoxyaryl, *e.g.,* C₃-C₈ alkyl-O-phenyl, and C₆-alkyl-O-phenyl 1, R₂ is hydrogen, and R₃ is hydrogen. In some embodiments, with regard to the compound of the formula (VII), R₄ is alkoxyaryl, *e.g.,* C₃-C₈ alkyl-O-phenyl, and C₆-alkyl-O-phenyl, R₂ is C₃-C₈ alkyl, *e.g.,* C₆ alkyl, and R₃ is hydrogen.

In some embodiments, with regard to the compound of the formula (VIII), R₄ is C₉-C₁₅ alkyl. In some embodiments, with regard to the compound of the formula (VIII), R₄ is alkoxyaryl, *e.g.,* C₃-C₈ alkyl-O-phenyl, and C₆-alkyl-O-phenyl. In some embodiments, with regard to the compound of the formula (VIII), R₄ is C₉-C₁₅ alkyl, R₂ is hydrogen, and R₃ is hydrogen. In some embodiments, with regard to the compound of the formula (VIII), R₄ is alkoxyaryl, *e.g.,* C₃-C₈ alkyl-O-phenyl, and C₆-alkyl-O-phenyl, R₂ is hydrogen, and R₃ is hydrogen.

In some embodiments, with regard to the compound of the formula (X), R₄ is C₉-C₁₅ alkyl. In some embodiments, with regard to the compound of the formula (X), R₄ is C₉-C₁₅ alkyl, R₂ is hydrogen, and R₃ is C₃-C₈ alkyl, *e.g.,* C₆ alkyl.

In some embodiments, the dye 16 comprises one or more dyes comprising a compound of the formula (I) defined by the formulae (XII)-(XVII), wherein n is an integer from 4 to 10, such that the alkyl chain on the nitrogen of the 10*H*-phenoxazine moiety is a C₉-C₁₅ alkyl chain:

| | |
|---|---|
| 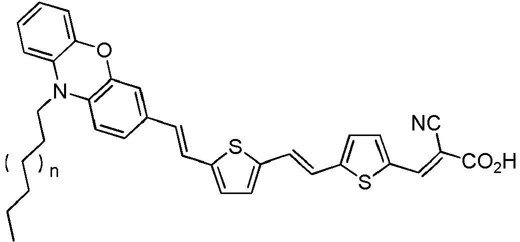 | (XII) |
| 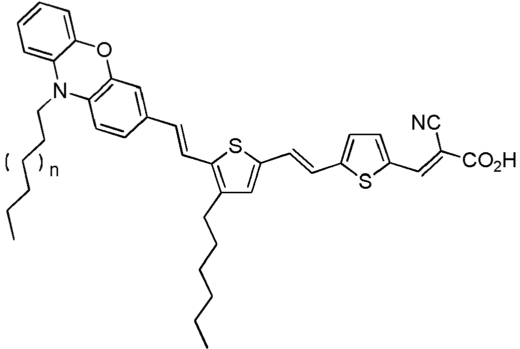 | (XIII) |
| 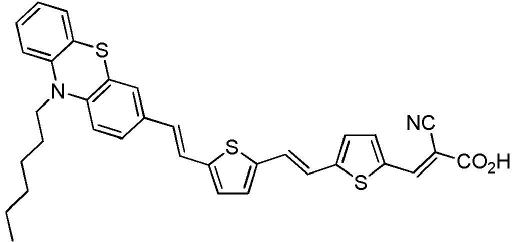 | (XIV) |
| 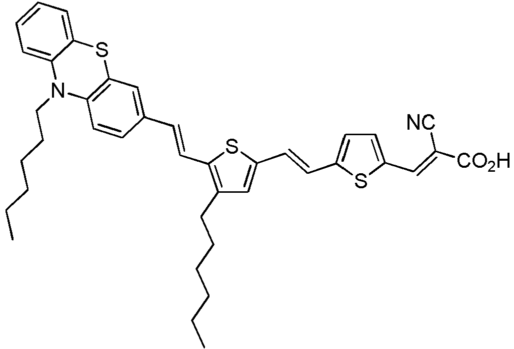 | (XV) |
| 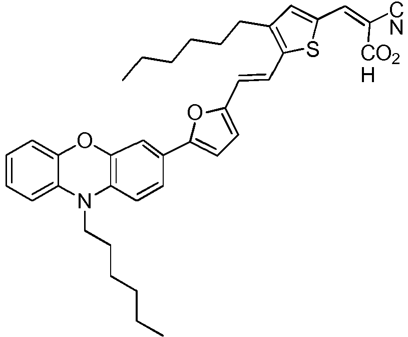 | (XVI) |
| 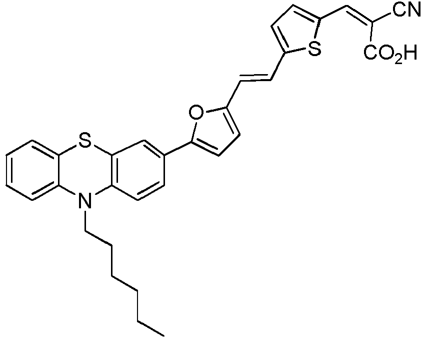 | (XVII) |

In some embodiments, the dye 16 comprises one or more dyes comprising a compound of the formula (I) defined by the formulae (XVIII)-(XXIV), wherein R₂ and R₃ are as defined above:

| | |
|---|---|
| 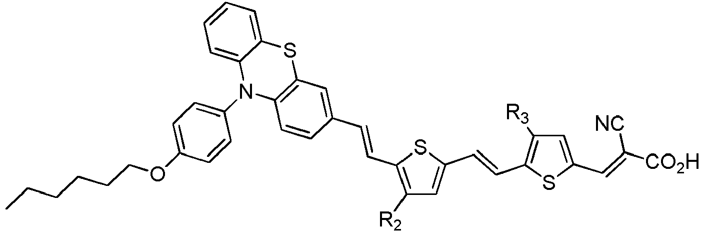 | (XVIII) |
| 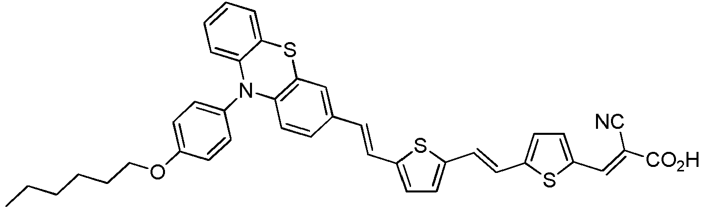 | (XIX) |
| 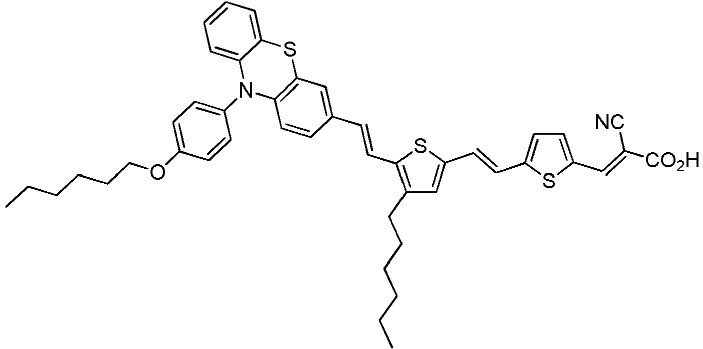 | (XX) |
| 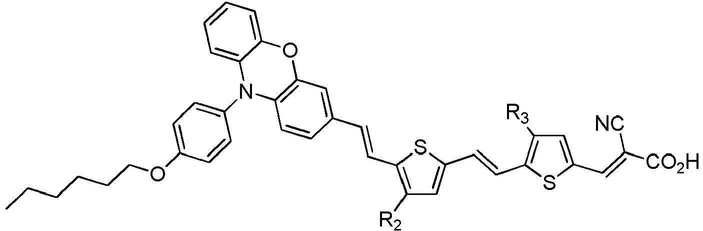 | (XXI) |
| 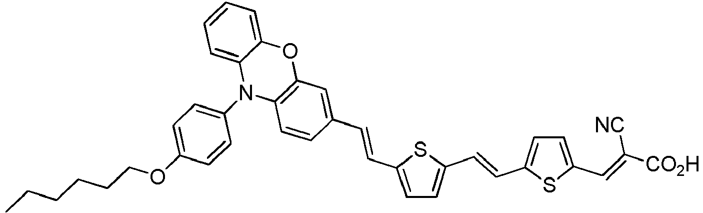 | (XXII) |
| 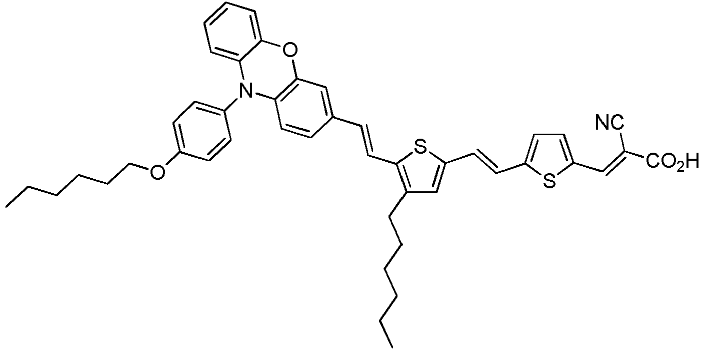 | (XXIII) |
| 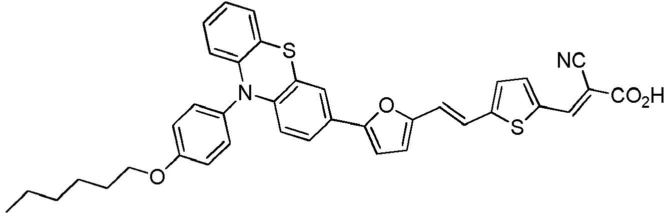 | (XXIV) |

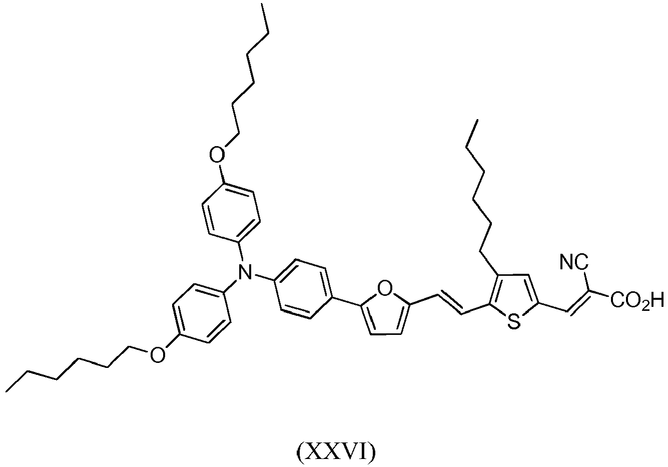

As used herein, the term "alkyl" refers broadly to a straight or branched chain saturated hydrocarbon radical. "Alkyl" also refers broadly to cyclic (*i.e.,* cycloalkyl) alkyl groups. Examples of alkyl groups include, but are not limited to, straight chained alkyl groups including methyl, ethyl, n-propyl, n-butyl, n-pentyl, n-hexyl, n-heptyl, n-octyl, and branched alkyl groups including isopropyl, tert-butyl, iso-amyl, neopentyl, iso-amyl, and the like. "Cycloalkyl" or "cyclic alkyl" as used herein refers to carbocycles containing no heteroatoms, and includes mono-, bi- and tricyclic saturated carbocycles, as well as fused ring systems. Examples of cycloalkyl include cyclopropyl, cyclobutyl, cyclopentyl, cyclohexyl, cycloheptyl, and the like. The cycloalkyl can be substituted or unsubstituted. Such alkyl groups may be optionally substituted as described herein. In some embodiments, the alkyl radical is a C₃-C₁₈ alkyl radical (*e.g.,* C₆-C₁₈, C₃-C₈, C₆-C₁₂ or C₅-C₈); or a C₉-C₁₅ alkyl radical (*e.g.,* C₉-C₁₂, C₁₀-C₁₅, C₁₂-C₁₅ or C₁₀-C₁₃).

As used herein, the term "C₂-C₅ alkenyl" refers broadly to a straight or branched chain hydrocarbon radical having one or more double bonds and containing from 2 to 5 carbon atoms. The double bonds may be in the cis or trans configuration. Such C₂-C₅ alkenyl groups may be optionally substituted as described herein Also contemplated are C₂-C₃ alkenyl and C₃-C₅ alkenyl. Examples of C₂-C₅ alkenyl groups include those shown in Table I, below, where the wavy lines indicate points of attachment to the compound of the formula (I) and the moiety of formula (II).

**Table I**

| Ethenyl | 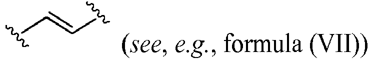 |
|---|---|
| Propenyl | 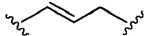 |
| Butenyl | 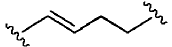 |
| Butadienyl | 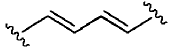 |
| Pentenyl | 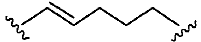 |
| Pentadienyl | 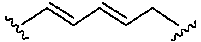 |

"Substituted" as used herein refers broadly to replacement of one or more of the hydrogen atoms of the group replaced by substituents known to those skilled in the art and resulting in a stable compound as described below. Examples of suitable replacement groups include, but are not limited to, alkyl, alkenyl, alkynyl, cycloalkyl, aryl, alkaryl, hydroxy, alkoxy, aryloxy, carboxy *(i.e.,* CO₂H), carboxyalkyl, carboxyaryl, cyano, nitro and the like.

The term "aryl" as used herein refers to an aromatic group, a heteroaryl group or to an optionally substituted aromatic group or heteroaryl group fused to one or more optionally substituted aromatic groups or heteroaryl groups, optionally substituted with suitable substituents including, but not limited to, lower alkyl, lower alkoxy, lower alkylsulfanyl, lower alkylsulfenyl, lower alkylsulfonyl, oxo, hydroxy, mercapto, amino optionally substituted by alkyl, carboxy, tetrazolyl, carbamoyl optionally substituted by alkyl, aminosulfonyl optionally substituted by alkyl, acyl, aroyl, heteroaroyl, acyloxy, aroyloxy, heteroaroyloxy, alkoxycarbonyl, nitro, cyano, halogen, or lower perfluoroalkyl, multiple degrees of substitution being allowed. Examples of aryl include, but are not limited to, phenyl, 2-naphthyl, 1-naphthyl, 4-pyridyl and the like.

The term "alkoxy" as used herein alone or as part of another group, refers to an alkyl group, as defined herein, appended to the parent molecular moiety through an oxy group. Representative examples of alkoxy include, but are not limited to, methoxy, ethoxy, propoxy, 2-propoxy, butoxy, tert-butoxy, pentyloxy, hexyloxy and the like.

The term "alkoxyaryl" as used herein refers to the group alkoxy-aryl-.

Compounds of the embodiments of the present invention may be synthesized according to Schemes I-II, where the compound of formula (XI) is specifically synthesized. Other compounds of the of the embodiments of the present invention may be synthesized similarly.

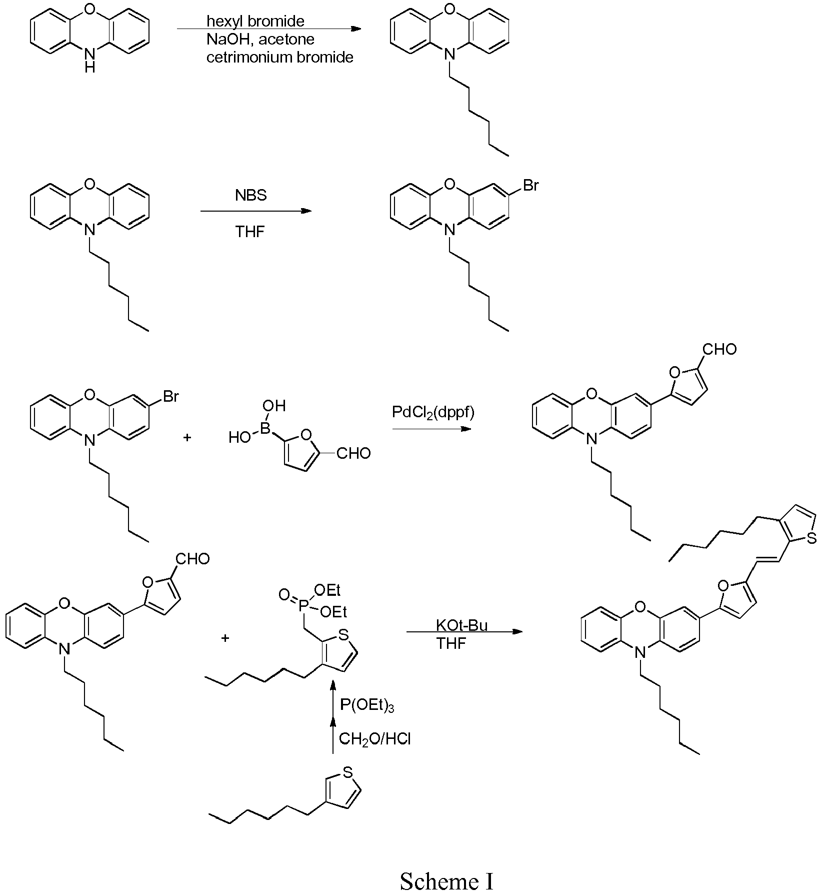

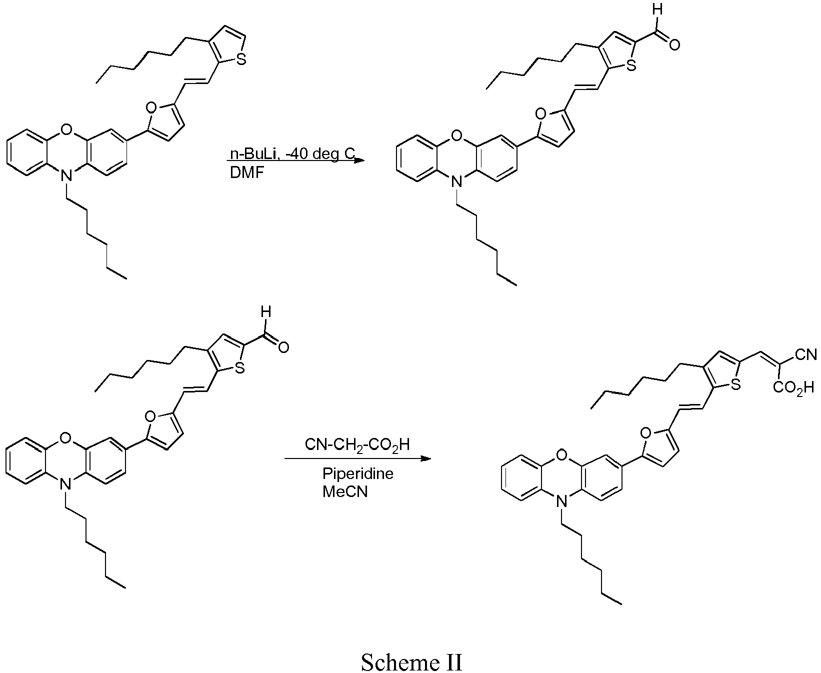

Referring to FIG. 2F, a second substrate 20 comprising a second conductive layer 22 is provided. The second conductive layer 22 is formed on the second substrate 20 by evaporation, sputtering, electroplating, deposition, or by any applicable process well-known in the art. The material of the second substrate 20 is the same or different from the material of the first substrate 10, as previously described. The second substrate 20 may comprise any suitable material and may be rigid, flexible, transparent, or semitransparent. In some embodiments, the second substrate 20 may be glass or polymeric (*e.g*., poly(ethylene terephthalate or poly(ethylene naphthalate) in nature. The second conductive layer 22 may be metal comprising copper, platinum, silver, or any conductive material. In some embodiments, the second substrate 20 comprises at least one orifice 18 that goes through the scond substrate 20 and the second conductive layer 22 and allows for the application of the regenerating composition 24.

In FIG. 1, a regenerating composition 24 is applied (*e.g.,* by filling via orifice 18 that goes through the second substrate 20 and the second conductive layer 22) between the first substrate 10 and the second substrate 20, to regenerate the dye 16. Those of skill in the art will appreciate that the regenerating composition 24, though shown as a layer in FIG. 1, will permeate the space between the barrier layer 11 and the second conductive layer 22.

In some embodiments, the regenerating composition 24 comprises iodide ion and iodine. The regenerating composition 24 may be a solution of iodide ion and iodine. For example, the regenerating composition 24 comprises lithium iodide (LiI) and iodine (I₂) each at a concentration of from about 0.1 M to about 0.2 M in an appropriate solvent such as acetonitrile, tetrahydrofuran, pyridine or a 5:1 mixture of acetonitrile/valeronitrile. In some embodiments, the regenerating composition 24 also comprises an imidazolium salt. Exemplary imidazolium salts include 1,2-dimethyl-3-propylimidazolium iodide and 1-butyl-2-methyl imidazolium iodide. In some embodiments, the regenerating composition 24 also comprises a substituted pyridine. Exemplary substituted pyridines include 4-tert-butyl pyridine. Other electrolytes include the Co(II)/Co(III) based redox couples.

Alternatively, the regenerating composition 24 may be in the form of a gel comprising iodide ion and iodine. *See, e.g.,* Published U.S. Patent Appl. No. 2008/0041446 and U.S. Patent No. 8,034,260, both of which are incorporated by reference as if fully set forth herein. Other regenerating compositions 24 are also known in the art and may be used in the embodiments of the present invention. *See, e.g.,* U.S. patent No. 8,222,515, which is incorporated by reference as if fully set forth herein.

In some embodiments, the regenerating composition 24 comprises 2,2'7,7'-tetrakis-(N,N-di-p-methoxyphenyl-amine)-9,9'-spirobifluorene (spiro-MeOTAD) or any other substance that can serve to regenerate the dye comprised in the dye layer 16 by reducing the dye comprised in the dye layer 16.

Following application of the regenerating composition 24 (e.g., by filling via orifice 18 that goes through the second substrate 20 and the second conductive layer) between the first substrate 10 and the second substrate 20, in some embodiments, a sealant (not shown) is applied to seal the DSSC. One of the functions of the sealant is to prevent the regenerating composition 24 from escaping from between the barrier layer 11 and the second conductive layer 22. Exemplary sealants include, but are not limited to Surlyn^{®} ethylene methacrylic acid copolymer resins available from DuPont™.

FIG. 3 shows a dye-sensitized solar cell 30 according to an embodiment of the invention. The dye 16 comprised in the nanoparticulate layer 14 and the microparticulate layer 13 is excited with light and transmits electrons into the nanoparticulate layer 14, when dye 16 absorbs solar energy. At this point, the dye 16 is in an oxidized state. As shown, an electric flow path 32 in FIG. 3, electrons are transmitted to the conductive layer 12 to the second conductive layer 22 to generate a current. Thereafter, electrons from regenerating composition 24 are provided to dye 16 for reduction of oxidized dye 16. The above oxidization and reduction of dye 16 is repeatedly performed to generate current continually.

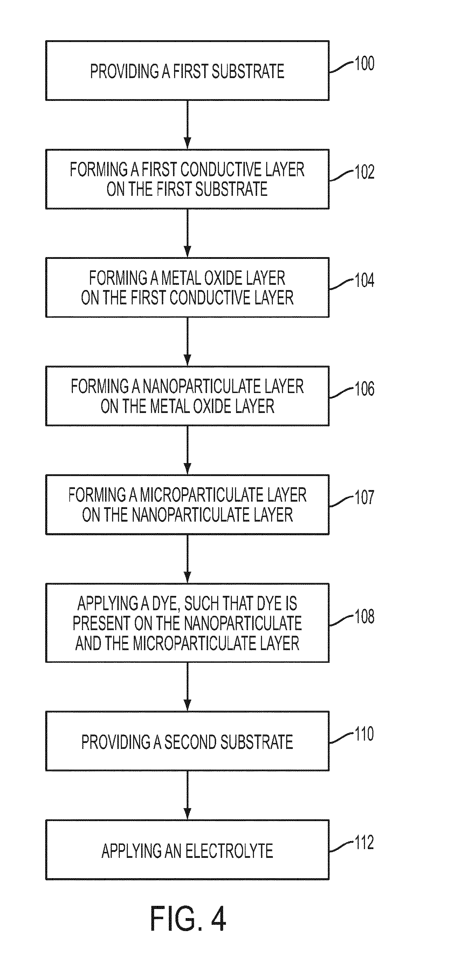

FIG. 4 shows a flow chart for making a dye-sensitized solar cell according to an embodiment of the invention. A first substrate is provided, as step 100. A first conductive layer is formed on the first substrate, as step 102. A barrier layer is formed on the first conductive layer, as step 104. A nanoparticulate layer, comprising a plurality of nanoparticles, is formed on the barrier layer, as step 106. A microparticulate layer is formed on the nanoparticulate layer, as step 107. A dye is then applied on the first substrate by dip coating, as step 108, such that the dye is present in the nanoparticulate layer and/or in the microparticulate layer. Thereafter, a second substrate is provided, as step 110, where the second substrate comprises a second conductive layer. As shown in step 112, a regenerating composition is applied between the substrates to yield a dye-sensitized solar cell, *e.g.,* through an orifice present on the second substrate, that goes through the second conductive layer. In some embodiments, a sealant is provided (step not shown) in a sealing step after the regenerating composition is applied.

### Examples

The following examples are set forth to assist in understanding the embodiments of the invention and should not, of course, be construed as specifically limiting the embodiments of the invention described and claimed herein.

### Example 1

A DSSC is prepared by deposition of several layers, including a TiO₂ nanoparticulate layer onto a fluorine-doped tin oxide glass substrate. The substrate comprising the TiO₂ nanoparticulate layer is dipped in a 0.3 mM solution of dye and allowed to soak in the dye solution for 30 minutes. After soaking, the substrate comprising the TiO₂ layer is washed in deionized water, dried, and then washed again in isopropanol.

The DSSC is assembled by placing the substrate comprising the TiO₂ nanoparticulate layer and dye on top of a back conductive surface having an orifice. An electrolyte containing 0.06 M LiI, 0.04 M I₂, 0.5 M 1-butyl-2-methyl imidazolium iodide, 0.5 M 4-tert-butylpyridine in 5:1 acetonitrile/valeronitrile is applied through the orifice, which is subsequently sealed. The completed DSSC is sealed with a low melting point polymer film that served as a gasket.

Embodiments of the invention described and claimed herein are not to be limited in scope by the specific embodiments herein disclosed, since these embodiments are intended as illustration of several aspects of the disclosure. Any equivalent embodiments are intended to be within the scope of this disclosure. Indeed, various modifications of the embodiments in addition to those shown and described herein will become apparent to those skilled in the art from the foregoing description. Such modifications are also intended to fall within the scope of the appended claims.

All publications, including non-patent literature (e.g., scientific journal articles), patent application publications, and patents mentioned in this specification are incorporated by reference as if each were specifically and individually indicated to be incorporated by reference.

Following application of the regenerating composition 24 *(e.g.,* by filling via orifice 18 that goes through the second substrate 20 and the second conductive layer) between the first substrate 10 and the second substrate 20, in some embodiments, a sealant (not shown) is applied to seal the DSSC. One of the functions of the sealant is to prevent the regenerating composition 24 from escaping from between the barrier layer 11 and the second conductive layer 22. Exemplary sealants include, but are not limited to Surlyn^{®} ethylene methacrylic acid copolymer resins available from DuPont™.

FIG. 3 shows a dye-sensitized solar cell 30 according to an embodiment of the invention. The dye 16 comprised in the nanoparticulate layer 14 and the microparticulate layer 13 is excited with light and transmits electrons into the nanoparticulate layer 14, when dye 16 absorbs solar energy. At this point, the dye 16 is in an oxidized state. As shown, an electric flow path 32 in FIG. 3, electrons are transmitted to the conductive layer 12 to the second conductive layer 22 to generate a current. Thereafter, electrons from regenerating composition 24 are provided to dye 16 for reduction of oxidized dye 16. The above oxidization and reduction of dye 16 is repeatedly performed to generate current continually.

FIG. 4 shows a flow chart for making a dye-sensitized solar cell according to an embodiment of the invention. A first substrate is provided, as step 100. A first conductive layer is formed on the first substrate, as step 102. A barrier layer is formed on the first conductive layer, as step 104. A nanoparticulate layer, comprising a plurality of nanoparticles, is formed on the barrier layer, as step 106. A microparticulate layer is formed on the nanoparticulate layer, as step 107. A dye is then applied on the first substrate by dip coating, as step 108, such that the dye is present in the nanoparticulate layer and/or in the microparticulate layer. Thereafter, a second substrate is provided, as step 110, where the second substrate comprises a second conductive layer. As shown in step 112, a regenerating composition is applied between the substrates to yield a dye-sensitized solar cell, *e.g.,* through an orifice present on the second substrate, that goes through the second conductive layer. In some embodiments, a sealant is provided (step not shown) in a sealing step after the regenerating composition is applied.

### Examples

The following examples are set forth to assist in understanding the embodiments of the invention and should not, of course, be construed as specifically limiting the embodiments of the invention described and claimed herein.

### Example 1

A DSSC is prepared by deposition of several layers, including a TiO₂ nanoparticulate layer onto a fluorine-doped tin oxide glass substrate. The substrate comprising the TiO₂ nanoparticulate layer is dipped in a 0.3 mM solution of dye and allowed to soak in the dye solution for 30 minutes. After soaking, the substrate comprising the TiO₂ layer is washed in deionized water, dried, and then washed again in isopropanol.

The DSSC is assembled by placing the substrate comprising the TiO₂ nanoparticulate layer and dye on top of a back conductive surface having an orifice. An electrolyte containing 0.06 M LiI, 0.04 M I₂, 0.5 M 1-butyl-2-methyl imidazolium iodide, 0.5 M 4-tert-butylpyridine in 5:1 acetonitrile/valeronitrile is applied through the orifice, which is subsequently sealed. The completed DSSC is sealed with a low melting point polymer film that served as a gasket.

Embodiments of the invention described and claimed herein are not to be limited in scope by the specific embodiments herein disclosed, since these embodiments are intended as illustration of several aspects of the disclosure. Any equivalent embodiments are intended to be within the scope of this disclosure. Indeed, various modifications of the embodiments in addition to those shown and described herein will become apparent to those skilled in the art from the foregoing description. Such modifications are also intended to fall within the scope of the appended claims.

## Claims

1. A dye-sensitized solar cell comprising one or more dyes **characterised in that** it comprises a compound of the formula (I): 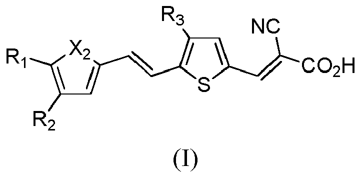 wherein R₁ is a moiety of the formula (II): 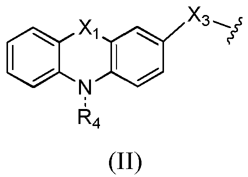 wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur.

2. A method of preparing a dye sensitized solar cell comprising:
forming a first conductive layer on a first substrate;
forming a barrier layer on the first conductive layer;
forming a TiO₂ nanoparticulate layer;
forming a TiO₂ microparticulate layer on the TiO₂ nanoparticulate layer;
disposing a dye on the TiO₂ nanoparticulate layer and/or the TiO₂ microparticulate layer, wherein the dye comprises a compound of the formula (I): 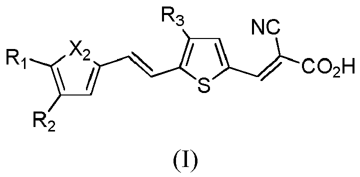
wherein R₁ is a moiety of the formula (II): 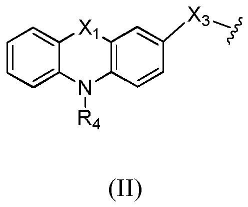
wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur;
forming a second conductive layer on a second substrate; and
providing a regenerating composition between the second conductive layer and
the barrier layer.

3. The dye-sensitized solar cell of claim 1, further comprising:
a first conductive layer disposed on a first substrate;
a barrier layer disposed on the first conductive layer;
a TiO₂ nanoparticulate layer disposed on the barrier layer;
a TiO₂ microparticulate layer disposed on the TiO₂ nanoparticulate layer;
a dye disposed on the TiO₂ nanoparticulate layer and/or the TiO₂ microparticulate layer, wherein the dye comprises a compound of the formula (I): 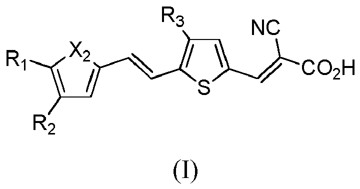
wherein R₁ is a moiety of the formula (II): 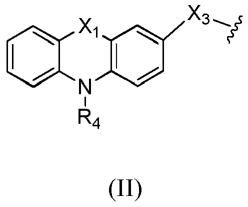
wherein the wavy lines indicate the point of attachment to the ring comprising X₂ at the point where R₁ is located; X₁ is oxygen or sulfur; X₃ is absent or C₂-C₅ alkenyl; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur;
a second conductive layer disposed on a second substrate; and
a regenerating composition disposed between the second conductive layer and
the TiO₂ microparticulate layer.

4. The method of claim 2 or the dye-sensitized solar cell of claim 3, wherein the wavy line indicates the point of attachment to the ring comprising X₂ at the point where R₁ is located; X₁ is oxygen or sulfur; X₃ is absent or C₂-C₅ alkenyl; and R₄ is alkoxyaryl or C₃-C₁₈ alkyl.

5. The method of claim 2 or the dye-sensitized solar cell of claim 3, wherein the compound of the formula (I) is a compound of the formula: 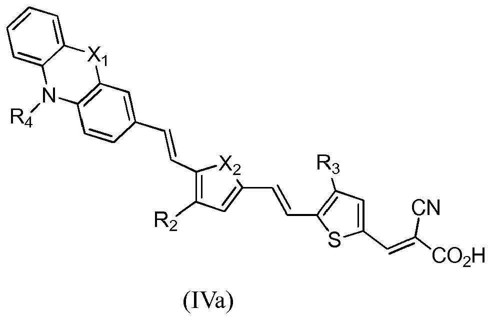 wherein X₁ is oxygen or sulfur; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur; or 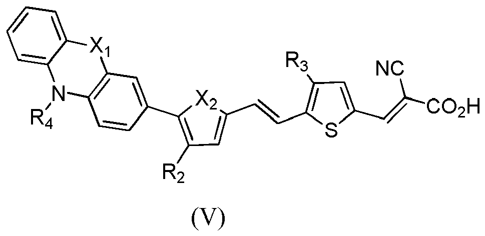 wherein X₁ is oxygen or sulfur; R₄ is alkoxyaryl or C₃-C₁₈ alkyl; R₂ is hydrogen or C₃-C₁₈ alkyl; R₃ is hydrogen or C₃-C₁₈ alkyl; and X₂ is oxygen or sulfur.

6. The method or dye-sensitized solar cell of claims 1 to 5 , wherein X₂ is oxygen.

7. The method or dye-sensitized solar cell of claims 1 to 5 , wherein X₂ is sulfur.

8. The method or dye-sensitized solar cell of claims 1 to 5, wherein X₁ is oxygen and X₂ is oxygen; X₁ is sulfur and X₂ is sulfur; X₁ is oxygen and X₂ is sulfur; or X₁ is sulfur and X₂ is oxygen.

9. The method of claim 2 or the dye-sensitized solar cell of claim 3, wherein the first and/or second substrate comprises glass or a flexible polymer.

10. The method or dye-sensitized solar cell of claim 8, wherein the first and/or second substrate comprises a flexible polymer comprising poly(ethylene terephthalate), poly(ethylene naphthalate) or mixtures thereof.

11. The method of claim 2 or the dye-sensitized solar cell of claim 3, wherein the first conductive layer comprises indium tin oxide (ITO), aluminum doped zinc oxide (AZO), antimony doped tin dioxide (ATO), fluorine doped tin dioxide (FTO), tin-doped indium oxide or conductive impurity doped titanium oxide (TiO₂).

12. The method of claim 2 or the dye-sensitized solar cell of claim 3, wherein the regenerating composition comprises iodide ions and iodine.

13. The method of claim 2 or the dye-sensitized solar cell of claim 3, wherein the second conductive layer comprises platinum.

## Patentansprüche

1. Farbstoffsensibilisierte Solarzelle, umfassend einen oder mehrere Farbstoffe, **dadurch gekennzeichnet, dass** sie eine Verbindung der Formel (I): 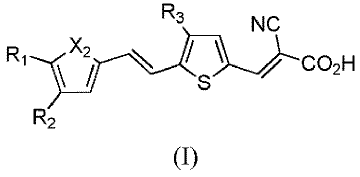 umfasst, wobei R₁ für eine Gruppierung der Formel (II) : 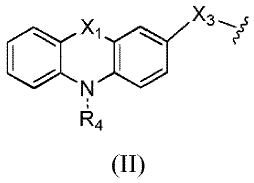 steht, wobei die Wellenlinien den Verknüpfungspunkt mit dem X₂ umfassenden Ring an dem Punkt, an dem sich R₁ befindet, anzeigen; X₁ für Sauerstoff oder Schwefel steht; X₃ fehlt oder für C₂-C₅-Alkenyl steht; R₄ für Alkoxyaryl oder C₃-C₁₈-Alkyl steht; R₂ für Wasserstoff oder C₃-C₁₈-Alkyl steht; R₃ für Wasserstoff oder C₃-C₁₈-Alkyl steht und X₂ für Sauerstoff oder Schwefel steht.

2. Verfahren zur Herstellung einer farbstoffsensibilisierten Solarzelle, bei dem man:
auf einem ersten Substrat eine erste leitfähige Schicht bildet;
auf der ersten leitfähigen Schicht eine Barriereschicht bildet;
eine TiO₂-Nanopartikelschicht bildet;
auf der TiO₂-Nanopartikelschicht eine TiO₂-Mikropartikelschicht bildet;
auf der TiO₂-Nanopartikelschicht und/oder der TiO₂-Mikropartikelschicht einen Farbstoff anordnet, wobei der Farbstoff eine Verbindung der Formel (I) : 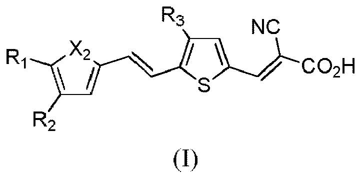
umfasst, wobei R₁ für eine Gruppierung der Formel (II) : 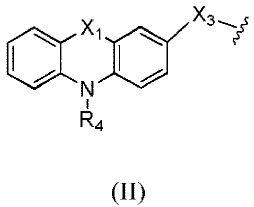
steht, wobei die Wellenlinien den Verknüpfungspunkt mit dem X₂ umfassenden Ring an dem Punkt, an dem sich R₁ befindet, anzeigen; X₁ für Sauerstoff oder Schwefel steht; X₃ fehlt oder für C₂-C₅-Alkenyl steht; R₄ für Alkoxyaryl oder C₃-C₁₈-Alkyl steht; R₂ für Wasserstoff oder C₃-C₁₈-Alkyl steht;
R₃ für Wasserstoff oder C₃-C₁₈-Alkyl steht und X₂ für Sauerstoff oder Schwefel steht;
auf einem zweiten Substrat eine zweite leitfähige Schicht bildet; und
zwischen der zweiten leitfähigen Schicht und der Barriereschicht eine Regenerationszusammensetzung bereitstellt.

3. Farbstoffsensibilisierte Solarzelle nach Anspruch 1, ferner umfassend:
eine auf einem ersten Substrat angeordnete erste leitfähige Schicht;
eine auf der ersten leitfähigen Schicht angeordnete Barriereschicht;
eine auf der Barriereschicht angeordnete TiO₂-Nanopartikelschicht;
eine auf der TiO₂-Nanopartikelschicht angeordnete TiO₂-Mikropartikelschicht;
einen auf der TiO₂-Nanopartikelschicht und/oder der TiO₂-Mikropartikelschicht angeordneten Farbstoff, wobei der Farbstoff eine Verbindung der Formel (I) : 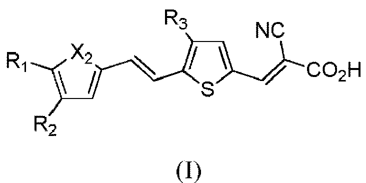
umfasst, wobei R₁ für eine Gruppierung der Formel (II) : 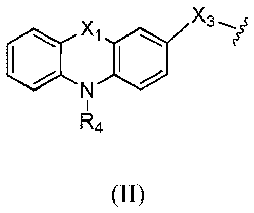
steht, wobei die Wellenlinien den Verknüpfungspunkt mit dem X₂ umfassenden Ring an dem Punkt, an dem sich R₁ befindet, anzeigen; X₁ für Sauerstoff oder Schwefel steht; X₃ fehlt oder für C₂-C₅-Alkenyl steht; R₄ für Alkoxyaryl oder C₃-C₁₈-Alkyl steht; R₂ für Wasserstoff oder C₃-C₁₈-Alkyl steht;
R₃ für Wasserstoff oder C₃-C₁₈-Alkyl steht und X₂ für Sauerstoff oder Schwefel steht;
eine auf einem zweiten Substrat angeordnete zweite leitfähige Schicht; und
eine zwischen der zweiten leitfähigen Schicht und der TiO₂-Mikropartikelschicht angeordnete Regenerationszusammensetzung.

4. Verfahren nach Anspruch 2 bzw. Farbstoffsensibilisierte Solarzelle nach Anspruch 3, wobei die Wellenlinie den Verknüpfungspunkt mit dem X₂ umfassenden Ring an dem Punkt, an dem sich R₁ befindet, anzeigen; X₁ für Sauerstoff oder Schwefel steht; X₃ fehlt oder für C₂-C₅-Alkenyl steht und R₄ für Alkoxyaryl oder C₃-C₁₈-Alkyl steht.

5. Verfahren nach Anspruch 2 bzw. Farbstoffsensibilisierte Solarzelle nach Anspruch 3, wobei es sich bei der Verbindung der Formel (I) um eine Verbindung der Formel: 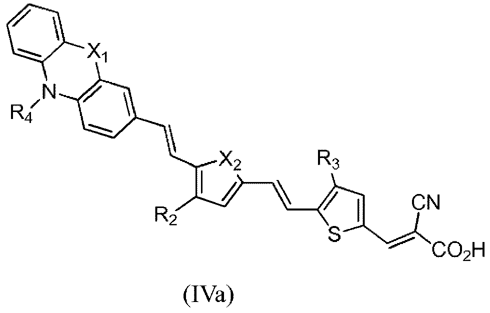 wobei X₁ für Sauerstoff oder Schwefel steht; R₄ für Alkoxyaryl oder C₃-C₁₈-Alkyl steht; R₂ für Wasserstoff oder C₃-C₁₈-Alkyl steht; R₃ für Wasserstoff oder C₃-C₁₈-Alkyl steht und X₂ für Sauerstoff oder Schwefel steht; oder 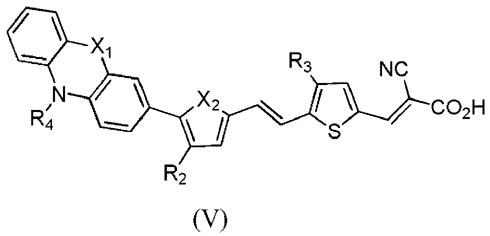 wobei X₁ für Sauerstoff oder Schwefel steht; R₄ für Alkoxyaryl oder C₃-C₁₈-Alkyl steht; R₂ für Wasserstoff oder C₃-C₁₈-Alkyl steht; R₃ für Wasserstoff oder C₃-C₁₈-Alkyl steht und X₂ für Sauerstoff oder Schwefel steht; handelt.

6. Verfahren bzw. farbstoffsensibilisierte Solarzelle nach den Ansprüchen 1 bis 5, wobei X₂ für Sauerstoff steht.

7. Verfahren bzw. farbstoffsensibilisierte Solarzelle nach den Ansprüchen 1 bis 5, wobei X₂ für Schwefel steht.

8. Verfahren bzw. farbstoffsensibilisierte Solarzelle nach den Ansprüchen 1 bis 5, wobei X₁ für Sauerstoff steht und X₂ für Sauerstoff steht; X₁ für Schwefel steht und X₂ für Schwefel steht; X₁ für Sauerstoff steht und X₂ für Schwefel steht oder X₁ für Schwefel steht und X₂ für Sauerstoff steht.

9. Verfahren nach Anspruch 2 bzw. farbstoffsensibilisierte Solarzelle nach Anspruch 3, wobei das erste und/oder das zweite Substrat Glas oder ein flexibles Polymer umfassen bzw. umfasst.

10. Verfahren bzw. farbstoffsensibilisierte Solarzelle nach Anspruch 8, wobei das erste und/oder das zweite Substrat ein flexibles Polymer, das Poly-(ethylenterephthalat), Poly(ethylennaphthalat) oder Mischungen davon umfasst, umfassen bzw. umfasst.

11. Verfahren nach Anspruch 2 bzw. farbstoffsensibilisierte Solarzelle nach Anspruch 3, wobei die erste leitfähige Schicht Indiumzinnoxid (ITO), aluminiumdotiertes Zinkoxid (AZO), antimondotiertes Zinndioxid (ATO), fluordotiertes Zinndioxid (FTO), zinndotiertes Indiumoxid oder mit leitfähigen Verunreinigungen dotiertes Titanoxid (TiO₂) umfasst.

12. Verfahren nach Anspruch 2 bzw. farbstoffsensibilisierte Solarzelle nach Anspruch 3, wobei die Regenerationszusammensetzung Iodidionen und Iod umfasst.

13. Verfahren nach Anspruch 2 bzw. farbstoffsensibilisierte Solarzelle nach Anspruch 3, wobei die zweite leitfähige Schicht Platin umfasst.

## Revendications

1. Cellule solaire à colorant comprenant un ou plusieurs colorants, **caractérisée en ce qu'**elle comprend un composé de formule (I) : 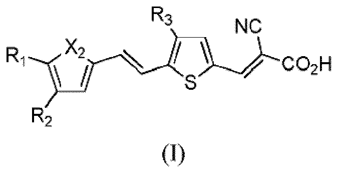 dans laquelle R₁ est une fraction de formule (II) : 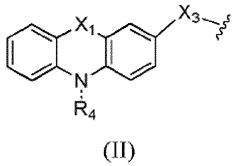 dans laquelle la ligne ondulée indique le point d'attache du cycle comprenant X₂ au point où est situé R₁ ; X₁ représente un oxygène ou un soufre ; X₃ est absent ou représente un alcényle en C₂-C₅ ; R₄ représente un alcoxyaryle ou un alkyle en C₃-C₁₈ ; R₂ représente un hydrogène ou un alkyle en C₃-C₁₈ ; R₃ représente un hydrogène ou un alkyle en C₃-C₁₈ ; et X₂ représente un oxygène ou un soufre.

2. Procédé de préparation d'une cellule solaire à colorant comprenant :
la formation d'une première couche conductrice sur un premier substrat ;
la formation d'une couche barrière sur la première couche conductrice ;
la formation d'une couche de nanoparticules de TiO₂ ;
la formation d'une couche de microparticules de TiO₂ sur la couche de nanoparticules de TiO₂ ;
la mise en place d'un colorant sur la couche de nanoparticules de TiO₂ et/ou la couche de microparticules de TiO₂, le colorant comprenant un composé de formule (I) : 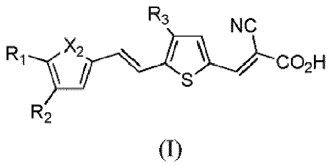
dans laquelle R₁ est une fraction de formule (II) : 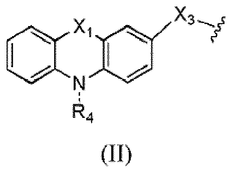
dans laquelle la ligne ondulée indique le point d'attache du cycle comprenant X₂ au point où est situé R₁ ; X₁ représente un oxygène ou un soufre ; X₃ est absent ou représente un alcényle en C₂-C₅ ; R₄ représente un alcoxyaryle ou un alkyle en C₃-C₁₈ ; R₂ représente un hydrogène ou un alkyle en C₃-C₁₈ ; R₃ représente un hydrogène ou un alkyle en C₃-C₁₈ ; et X₂ représente un oxygène ou un soufre ;
la formation d'une deuxième couche conductrice sur un deuxième substrat ; et
l'application d'une composition de régénération entre la deuxième couche conductrice et la couche barrière.

3. Cellule solaire à colorant selon la revendication 1, comprenant en outre :
une première couche conductrice disposée sur un premier substrat ;
une couche barrière disposée sur la première couche conductrice ;
une couche de nanoparticules de TiO₂ disposée sur la couche barrière ;
une couche de microparticules de TiO₂ disposée sur la couche de nanoparticules de TiO₂ ;
un colorant disposé sur la couche de nanoparticules de TiO₂ et/ou la couche de microparticules de TiO₂, le colorant comprenant un composé de formule (I) : 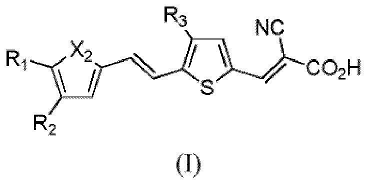
dans laquelle R₁ est une fraction de formule (II) : 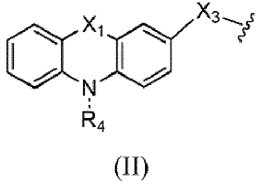
dans laquelle la ligne ondulée indique le point d'attache du cycle comprenant X₂ au point où est situé R₁ ; X₁ représente un oxygène ou un soufre ; X₃ est absent ou représente un alcényle en C₂-C₅ ; R₄ représente un alcoxyaryle ou un alkyle en C₃-C₁₈ ; R₂ représente un hydrogène ou un alkyle en C₃-C₁₈ ; R₃ représente un hydrogène ou un alkyle en C₃-C₁₈ ; et X₂ représente un oxygène ou un soufre ;
une deuxième couche conductrice disposée sur un deuxième substrat ; et
une composition de régénération disposée entre la deuxième couche conductrice et la couche de microparticules de TiO₂.

4. Procédé selon la revendication 2 ou cellule solaire à colorant selon la revendication 3, dans lesquels la ligne ondulée indique le point d'attache du cycle comprenant X₂ au point où est situé R₁ ; X₁ représente un oxygène ou un soufre ; X₃ est absent ou représente un alcényle en C₂-C₅ ; et R₄ représente un alcoxyaryle ou un alkyle en C₃-C₁₈.

5. Procédé selon la revendication 2 ou cellule solaire à colorant selon la revendication 3, dans lesquels le composé de formule (I) est un composé de formule : 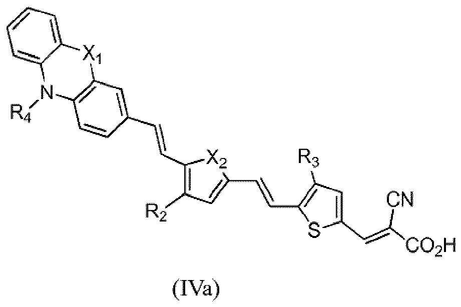 dans laquelle X₁ représente un oxygène ou un soufre ; R₄ représente un alcoxyaryle ou un alkyle en C₃-C₁₈ ; R₂ représente un hydrogène ou un alkyle en C₃-C₁₈ ; R₃ représente un hydrogène ou un alkyle en C₃-C₁₈ ; et X₂ représente un oxygène ou un soufre ; ou 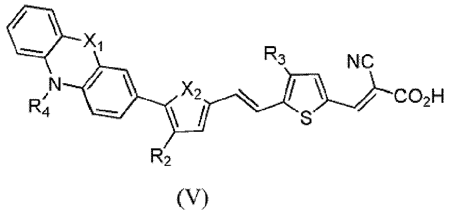 dans laquelle X₁ représente un oxygène ou un soufre ; R₄ représente un alcoxyaryle ou un alkyle en C₃-C₁₈ ; R₂ représente un hydrogène ou un alkyle en C₃-C₁₈ ; R₃ représente un hydrogène ou un alkyle en C₃-C₁₈ ; et X₂ représente un oxygène ou un soufre.

6. Procédé ou cellule solaire à colorant selon les revendications 1 à 5, dans lesquels X₂ représente un oxygène.

7. Procédé ou cellule solaire à colorant selon les revendications 1 à 5, dans lesquels X₂ représente un soufre.

8. Procédé ou cellule solaire à colorant selon les revendications 1 à 5, dans lesquels X₁ représente un oxygène et X₂ représente un oxygène ; X₁ représente un soufre et X₂ représente un soufre ; X₁ représente un oxygène et X₂ représente un soufre ; ou X₁ représente un soufre et X₂ représente un oxygène.

9. Procédé selon la revendication 2 ou cellule solaire à colorant selon la revendication 3, dans lesquels le premier et/ou le deuxième substrat comprennent du verre ou un polymère souple.

10. Procédé ou cellule solaire à colorant selon la revendication 8, dans lesquels le premier et/ou le deuxième substrat comprennent un polymère souple comprenant du poly(téréphtalate d'éthylène), du poly(naphtalate d'éthylène) ou un mélange de ceux-ci.

11. Procédé selon la revendication 2 ou cellule solaire à colorant selon la revendication 3, dans lesquels la première couche conductrice comprend de l'oxyde d'indium et d'étain (ITO), de l'oxyde de zinc dopé à l'aluminium (AZO), du dioxyde d'étain dopé à l'antimoine (ATO), du dioxyde d'étain dopé au fluor (FTO), de l'oxyde d'indium dopé à l'étain ou de l'oxyde de titane dopé par une impureté conductrice (TiO₂).

12. Procédé selon la revendication 2 ou cellule solaire à colorant selon la revendication 3, dans lesquels la composition de régénération comprend des ions iodure et de l'iode.

13. Procédé selon la revendication 2 ou cellule solaire à colorant selon la revendication 3, dans lesquels la deuxième couche conductrice comprend du platine.
